# EUROPÄISCHE PATENTANMELDUNG

(11) **EP 1 796 443 A1**
(43) Veröffentlichungstag der Anmeldung: **13.06.2007**
(21) Anmeldenummer: 05027000.8
(22) Anmeldetag: 09.12.2005
(51) Int. Cl.: H05K 1/00

(54) **Kontaktelement und elektrisches Verbindungssystem**

(71) Anmelder: Delphi Technologies, Inc., Troy, MI 48007 (US)
(72) Erfinder: Gärtner, Markus, 42117 Wuppertal (DE); Schmitz, Klaus Dieter, 42553 Velbert (DE); Kaluba, Thomas, 42659 Solingen (DE)
(74) Vertreter: Manitz, Finsterwald & Partner GbR

(57) **Zusammenfassung**

Die Erfindung betrifft ein elektrisches Kontaktelement mit einer Oberfläche, wenigstens einer Leiterbahn auf der Oberfläche und wenigstens einer Öffnung in der Oberfläche für einen Kontaktstift. Die Öffnung ist von einem abgesenkten, zumindest teilweise metallisierten Bereich der Oberfläche umgeben, dessen Metallisierung mit der Leiterbahn in elektrischem Kontakt ist. Die Erfindung betrifft weiterhin ein elektrisches Verbindungssystem mit einem erfindungsgemäßen Kontaktelement und einem Kontaktstift zur Aufnahme in der wenigstens einen Öffnung des Kontaktelements.

## Beschreibung

Die Erfindung betrifft ein elektrisches Kontaktelement mit einer Oberfläche, wenigstens einer Leiterbahn auf der Oberfläche und wenigstens einer, vorzugsweise durchgehenden, Öffnung in der Oberfläche für einen Kontaktstift. Weiterhin betrifft die Erfindung ein elektrisches Verbindungssystem mit einem elektrischen Kontaktelement und ein Verfahren zur Herstellung eines elektrischen Verbindungssystems.

Zur elektrischen Verbindung eines Kontaktstiftes mit einer Leiterbahn wird bei bekannten Lösungen der Kontaktstift in einer Durchgangsöffnung einer gedruckten Leiterplatte befestigt, wobei die Durchgangsöffnung sich im Bereich der Leiterbahn befindet. Der Kontakt wird durch Löten zwischen dem Kontaktstift und der Leiterbahn auf der Leiterplatte hergestellt. Damit die Verankerung des Kontaktstifts in der dünnen gedruckten Leiterplatte stabil genug ist, muss der Lötmeniskus, mit dem der Kontaktstift an der Leiterbahn kontaktiert wird, ausreichend groß gewählt werden. Die Kontaktstifte stehen dazu über die Oberfläche der Leiterplatte über, um an ihren Seitenflächen eine Angriffsfläche für die Lötpaste bereitzustellen.

Eine kostengünstige Methode zum Aufbringen von Lötpaste ist das Aufdrucken mit Hilfe einer Rakel, die eingesetzt wird, um die Lötpaste auf der Oberfläche zu verstreichen. Damit die Rakel nicht mit überstehenden Kontaktstiften kollidiert, müssen besondere Vorkehrungen und Anordnungen gewählt werden.

Aufgabe der vorliegenden Erfindung ist es, ein elektrisches Kontaktelement und ein elektrisches Verbindungssystem anzugeben, mit denen eine einfache und kostengünstige elektrische Verbindung zwischen Leiterbahnen und Kontaktstiften möglich ist.

Diese Aufgabe wird mit einem elektrischen Kontaktelement (im folgenden auch einfach "Kontaktelement") mit den Merkmalen des Anspruchs 1 bzw. ein elektrisches Verbindungssystem mit den Merkmalen des Anspruchs 6 gelöst. Anspruch 15 ist auf ein Verfahren zur Herstellung eines erfindungsgemäßen elektrischen Verbindungssystems gerichtet.

Ein erfindungsgemäßes Kontaktelement weist um eine Öffnung, durch die der Kontaktstift gesteckt werden kann, einen abgesenkten Bereich der Oberfläche auf, der zumindest teilweise metallisiert ist. Ein solcher abgesenkter Bereich ermöglicht es, dass der Kontaktstift so weit in das Kontaktelement eingesteckt werden kann, dass er eine Rakel beim Auftragen der Lötpaste nicht behindert. Insbesondere kann der Kontaktstift dazu so weit in die Öffnung eingesteckt werden, dass er nicht über die Oberfläche des Kontaktelements hinausragt. Zumindest kann er jedoch so weit eingesteckt werden, dass er nicht über eine Druckschablone hinausragt, die auf das Kontaktelement für den Auftrag der Lötpaste aufgelegt ist.

Durch den abgesenkten Bereich in der Oberfläche ist außerdem sichergestellt, dass sich die Lötpaste in dem abgesenkten Bereich sammelt und so optimal um den Kontaktstift anordnet.

Da außerdem kein Überstand des Kontaktstifts über die Oberfläche notwendig ist, kann der einzelne Stift kürzer und damit kostengünstiger gewählt werden.

Die erfindungsgemäße Ausgestaltung des Kontaktelements ermöglicht es insbesondere, dass eine große Anzahl Kontaktelemente parallel prozessiert werden können, wobei keine besondere Ausgestaltung der Rakel notwendig ist, um beim Auftragen der Lötpaste eine Kollision der Rakel mit Überständen der Kontaktstifte zu verhindern.

Eine besonders gute Lokalisierung der Lötpaste in dem abgesenkten Bereich um den Kontaktstift herum wird durch eine trichterförmige Ausgestaltung des abgesenkten Bereichs erreicht.

Vorzugsweise ist der abgesenkte Bereich vollständig metallisiert, um eine gleichmäßige Verteilung der Lötpaste beim Lötprozess und dem dazu durchgeführten Erwärmungsprozess zu gewährleisten.

Bei einer besonders bevorzugten Ausführungsform umfasst das Kontaktelement einen Schaltungsträger in Form eines Formkunststoffteiles. Das Kunststoffteil kann im Gegensatz zu einer gedruckten Leiterplatte ausreichend dick dimensioniert werden, dass der Kontaktstift ausreichenden mechanischen Halt in dem Schaltungsträger erfährt. Die Lötstelle selbst ist dann nahezu keinen oder überhaupt keinen mechanischen Beanspruchungen mehr ausgesetzt. Der Schaltungsträger kann außerdem problemlos derart dimensioniert werden, dass trotz eines abgesenkten Bereichs in der Oberfläche zur Aufnahme der Lötpaste ausreichend mechanische Stabilität gewährleistet ist. Die Dimensionen, z. B. die Dicke des Schaltungsträgers, werden im Bereich der Durchgangsöffnung dazu derart gewählt, dass der Kontaktstift auch ohne den abschließenden Lötprozess bereits fest in der Durchgangsöffnung gehalten ist. Das Formkunststoffteil ist dazu auf jeden Fall dicker als eine herkömmliche gedruckte Leiterplatte gewählt. Die optimale Mindestdicke ist auch von der Dicke des Kontaktstifts abhängig, wird vorzugsweise jedoch größer als 1,8 mm gewählt.

Vorteilhafterweise befindet sich bei einer solchen Ausführungsform die mit dem Kontaktstift zu verbindende Leiterbahn ohne gesonderte Leiterplatte direkt auf der Oberfläche des Schaltungsträgers.

Besonders vorteilhaft ist die erfindungsgemäße Anordnung bei einem spritzgegossenen Schaltungsträger (molded interconnect device, MID) als Kontaktelement, da sich bei einem solchen Bauteil die abgesenkten Bereiche bei dem Spritzgussprozess sehr einfach herstellen lassen.

Ein erfindungsgemäßes elektrisches Verbindungssystem weist ein erfindungsgemäßes Kontaktelement und einen Kontaktstift zur Aufnahme in der wenigstens einen Öffnung des Kontaktelements auf.

Die Vorteile eines elektrischen Verbindungssystems im speziellen mit einem Kontaktelement gemäß den oben geschilderten Ausgestaltungen ergeben sich aus den dort angegebenen Vorteilen.

Bei einer Weiterbildung des elektrischen Verbindungssystems ist der Kontaktstift derart ausgestaltet, dass er die Oberfläche des Kontaktelements, in der sich der abgesenkte Bereich befindet, nur maximal so weit überragt, dass er nicht höher als die Dicke einer Druckschablone über die Oberfläche hervorsteht, wenn er sich in der wenigstens einen Öffnung des Kontaktelements befindet. So ist sichergestellt, dass beim Auftragen der Lötpaste mit Hilfe einer Rakel der Kontaktstift nicht mit der Rakel kollidieren kann. Vorteilhaft wird der Kontaktstift derart ausgestaltet, dass er maximal 200 µm, bevorzugt maximal 90 µm, über die Oberfläche des Kontaktelements hervorsteht. Besonders günstig ist die Ausgestaltung, wenn der Kontaktstift die Oberfläche des Kontaktelements überhaupt nicht überragt.

Bei einer bevorzugten Ausgestaltung ist der wenigstens eine Kontaktstift derart ausgestaltet, dass er in der Öffnung des Kontaktelements verankerbar ist. Damit wird zusätzlich sichergestellt, dass die Lötstelle im Wesentlichen nur zur Herstellung der elektrischen Verbindung dient und mechanische Kräfte direkt von dem Kontaktstift in das Kontaktelement abgeleitet werden. Die Lötstelle wird auf diese Weise gegen Zug-, Druck- und Biegekräfte entlastet.

Die Erfindung betrifft zum einen elektrische Verbindungssysteme, bei denen der bzw. die Kontaktstifte und das Kontaktelement noch unverbunden sind und erst verwenderseitig verlötet werden. Andererseits betrifft die Erfindung elektrische Verbindungssysteme, bei denen die Verbindung zwischen Kontaktstiften und Kontaktelement bereits hergestellt ist und insofern der abgesenkte Bereich bereits mit Lötpaste gefüllt ist.

Der wenigstens eine Kontaktstift kann in der Öffnung des Kontaktelements z.B. mit Widerhaken gehalten sein. Bei einer anderen Ausgestaltung umfasst der Kontaktstift einen Rundstift mit einem Sternkopf, der z.B. in die Öffnung des Kontaktelements eingepresst werden kann, um eine sichere und feste mechanische Verbindung zu gewährleisten.

Bei einer anderen bevorzugten Ausgestaltung, bei der das Kontaktelement spritzgegossen ist, wird der wenigstens eine Kontaktstift bereits beim Spritzgießprozess umspritzt und so in das Kontaktelement fest integriert. Selbstverständlich kann auch dann der Kontaktstift über zusätzliche, die Verbindung stabilisierende Halteelemente verfügen, wie z.B. die oben bereits erwähnten Widerhaken oder einen Sternkopf. Das direkte Umspritzen vermeidet den zusätzlichen Schritt des Einsetzens des Kontaktstifts in die Öffnung des Kontaktelements.

Die Erfindung betrifft weiterhin ein Verfahren zur Herstellung eines elektrischen Verbindungssystems, bei dem eine Druckschablone mit einer Druckaussparung derart auf ein erfindungsgemäßes Kontaktelement mit wenigstens einem Kontaktstift aufgebracht wird, dass die Druckaussparung den Kontaktstift freilässt, und Lötpaste mit einer Rakel in die Druckaussparung gestrichen wird, wobei die Rakel über die Druckaussparung und den Kontaktstift gestrichen wird. Eine besondere Ausgestaltung oder Anordnung der Rakel zur Verhinderung einer möglichen Kollision mit einem Überstand des Kontaktstifts ist nicht notwendig.

Insbesondere vereinfacht die Erfindung auch die Automatisierung des Herstellungsprozesses, da keine Vorkehrungen getroffen werden müssen, dass die Rakel beim Lötpastenauftrag nicht mit den Kontaktsstiften kollidiert.

Die Erfindung wird anhand der beiliegenden Figuren im Detail erläutert, die in schematischer Darstellung Ausführungsformen bzw. Ausgestaltungen des erfindungsgemäßen Kontaktelements, des erfindungsgemäßen Verbindungssystems bzw. des erfindungsgemäßen Verfahrens darstellen. Es zeigt
- Fig. 1: einen seitlichen Schnitt durch ein erfindungsgemäßes elektrisches Verbindungssystem,
- Fig. 2: einen Schritt bei dessen Herstellung,
- Fig. 3: einen zweiten Schritt bei dessen Herstellung,
- Fig. 4: einen Zwischenzustand bei der Herstellung eines erfindungsgemäßen elektrischen Verbindungssystems im seitlichen Schnitt,
- Fig. 5: einen weiteren Schritt bei der Herstellung eines erfindungsgemäßen elektrischen Verbindungssystems,
- Fig. 6: eine perspektivische Teilansicht eines erfindungsgemäßen elektrischen Verbindungssystems während der Herstellung,
- Fig. 7: einen seitlichen Schnitt durch eine andere Ausführungsform eines erfindungsgemäßen elektrischen Verbindungssystems während der Herstellung,
- Fig. 8: eine perspektivische Teilschnittansicht eines erfindungsgemäßen elektrischen Verbindungssystems während der Herstellung, und
- Fig. 9: eine erläuternde Figur zu einem Schritt bei der Herstellung eines konventionellen elektrischen Verbindungssystems.

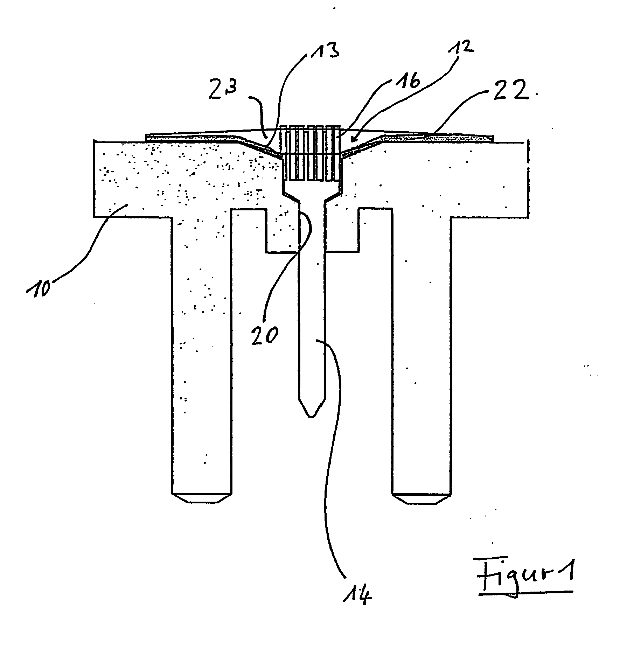

Fig. 1 zeigt den seitlichen Schnitt durch eine Ausführungsform des erfindungsgemäßen elektrischen Verbindungssystems. Ein spritzgegossener Schaltungsträger 10 (molded interconnected device, MID) weist eine Durchgangsöffnung 20 für einen Kontaktstift 14 auf. Auf dem Schaltungsträger ist eine z.B. aus Kupfer gefertigte Leiterbahn 22 in an sich bekannter Weise aufgebracht. Im Bereich der Durchgangsöffnung 20 weist der Schaltungsträger 10 einen trichterförmig abgesenkten Bereich 12 mit einer Metallisierung 13 in Form einer Metallschicht auf, die mit der Leiterbahn 22 verbunden ist. Der gesamte abgesenkte Bereich ist so metallisiert.

Der Kontaktstift 14 ist im Wesentlichen zylindrisch und weist an seinem oberen Ende einen Sternkopf 16 auf. Auf der Leiterbahn 22 befindet sich Lötpaste 23, die nach dem für den Lötprozess notwendigen Erwärmungsschritt eine elektrische Verbindung zwischen der Metallisierung 13 und dem Sternkopf 16 des Kontaktstifts 14 zur Verfügung stellt.

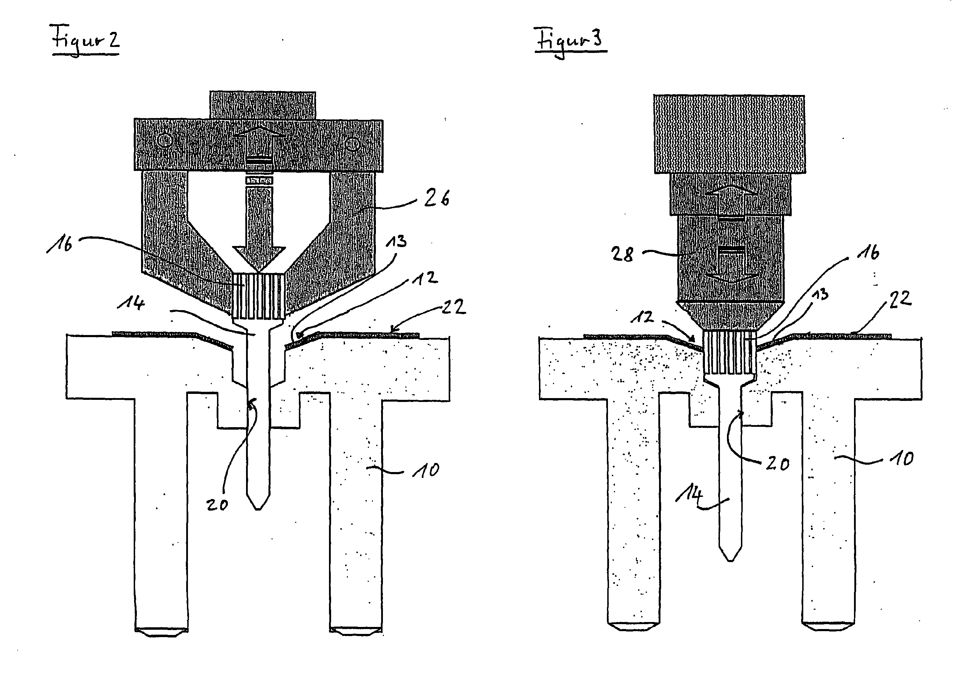

Die Fig. 2 bis 5 betreffen den Herstellungsprozess für eine solche Ausführungsform des erfindungsgemäßen elektrischen Verbindungssystems.

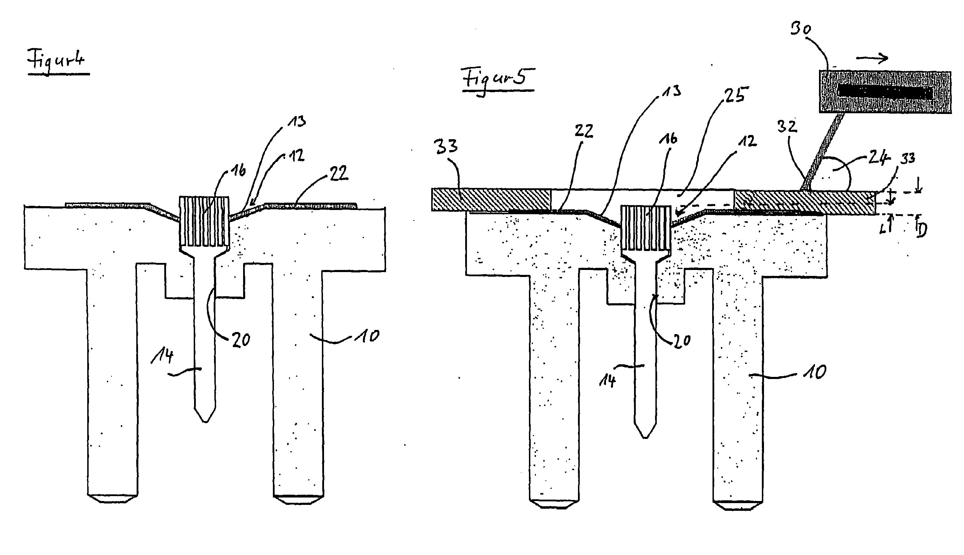

Fig. 2 zeigt, wie der Kontaktstift mit Hilfe eines Einsteckwerkzeugs 26 automatisch vorgesetzt wird. Das Einsteckwerkzeug 26 bewegt sich dabei in der angegebenen Pfeilrichtung nach unten. Fig. 3 zeigt den ebenfalls nach unten wirkenden Nachdrückprozess mit Hilfe eines Nachdrückwerkzeugs 28, der ebenfalls automatisiert durchgeführt werden kann. Es entsteht so der Zustand, der in Fig. 4 gezeigt ist.

Abweichend von dem gezeigten und beschriebenen Herstellungsprozess kann die Anordnung der Fig. 4 auch erhalten werden, wenn der Kontaktstift 14 beim Spritzgießprozess zur Herstellung des MID 10 gleich mit eingegossen bzw. umspritzt wird. Der Kontaktstift 14 ist dann gleich in das MID 10 integriert und man spart den aufwändigeren Einsteck- und Nachdrückprozess.

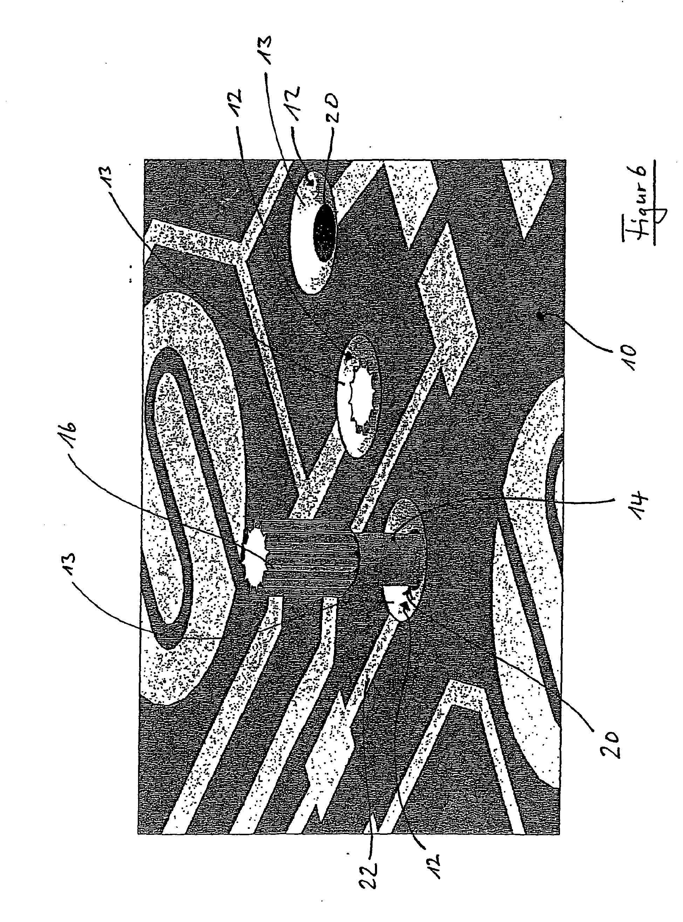

In einem nächsten Schritt (Fig. 5) wird eine Druckschablone 33 aufgelegt, die eine Aussparung im Bereich des Kontaktstifts 14 aufweist. Mit Hilfe der Rakel 32 eines Rakelwerkzeugs 30 wird Lötpaste 24 über die Druckschablone gestrichen. Das Rakelwerkzeug 30 mit der Rakel 32 wird dazu in der angegebenen Pfeilrichtung über die Aussparung in der Druckschablone 33 bewegt. In Fig. 5 ist dieser Schritt bereits vollzogen, so dass die verstrichene Lötpaste 25 sich bereits in der Aussparung der Druckschablone 33 befindet und den Sternkopf 16 des Kontaktstifts 14 umschließt, insbesondere in dem abgesenkten Bereich 12 des spritzgegossenen Schaltungsträgers 10.

In Fig. 5 ist deutlich erkennbar, dass der Kontaktstift 14 nur um eine Länge L über die obere Oberfläche des spritzgegossenen Schaltungsträgers 10 hinausragt, die kleiner ist als die Dicke D der Druckschablone 33 (die z.B. 90 bis 200 µm dick ist). So ist sichergestellt, dass beim Verstreichen der Lötpaste 24 mit Hilfe der Rakel 32 keine Behinderung der Bewegung der Rakel 32 durch eine Kollision mit dem Kontaktstift 14 bzw. dessen Sternkopf möglich ist.

Bei einer besonderen sicheren und günstigen Ausgestaltung, die in den Figuren nicht dargestellt ist, hat der Kontaktstift 14 überhaupt keinen Überstand über die obere Oberfläche des spritzgegossenen Schaltungsträgers 10, d.h. die Länge L ist kleiner oder gleich null.

Nach dem darauf folgenden Lötprozess, insbesondere nach dem Entfernen der Druckschablone 33 und dem Erwärmen der Lötpaste, entsteht der Zustand der Fig. 1, also des fertig gestellten erfindungsgemäßen elektrischen Verbindungssystems.

Fig. 6 zeigt in perspektivischer Darstellung den Blick auf eine Oberfläche eines spritzgegossenen Schalterträgers 10, der mehrere Leiterbahnen 22 aufweist. Erkennbar sind drei erfindungsgemäß abgesenkte Bereiche 12 mit Metallisierungen 13. Im rechten abgesenkten Bereich 12 ist noch kein Kontaktstift eingesteckt, so dass die Durchgangsöffnung 20 erkennbar ist.

Im linken abgesenkten Bereich 12 ist bereits ein Kontaktstift mit einem Sternkopf 16 am oberen Ende zum Teil eingeführt. Im mittleren abgesenkten Bereich ist der Kontaktstift bereits eingepresst, so dass hier ein Zustand vorliegt, wie er in Fig. 4 im Schnitt gezeigt ist. Der Sternkopf 16 des Kontaktstifts stellt hier eine besonders feste mechanische Verankerung des Kontaktstifts in der Durchgangsöffnung 20 zur Verfügung.

Mehrere spritzgegossene Schaltungsträger 10 können parallel prozessiert werden, insbesondere weil die Kontaktstifte im eingesteckten Zustand das Verstreichen der Lötpaste mit Hilfe einer Rakel nicht behindern.

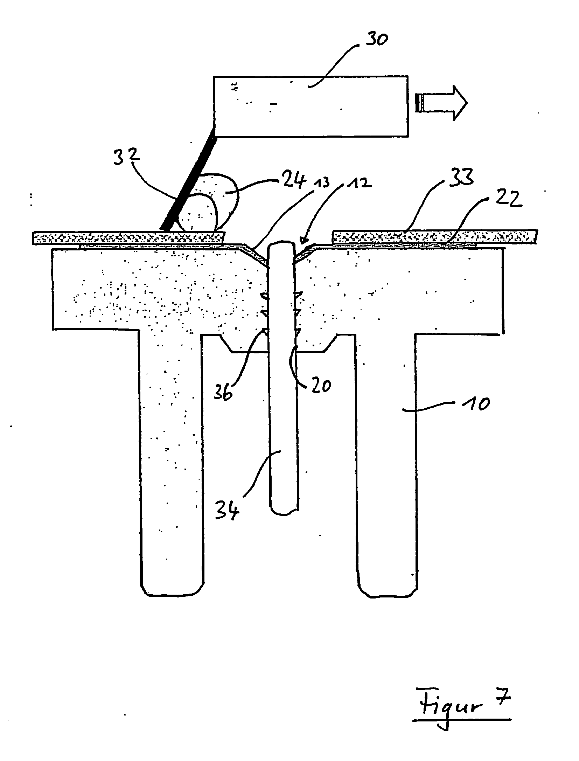

Fig. 7 zeigt im Schnitt eine andere Ausgestaltung eines erfindungsgemäßen elektrischen Verbindungssystems während der Herstellung. Hier ist ein Kontaktstift 34 mit Widerhaken 36 vorgesehen, der in den spritzgegossenen Schaltungsträger 10 eingepresst ist oder bereits bei der Herstellung des Schaltungsträgers mit eingespritzt worden ist. Auf diese Weise ist eine feste mechanische Verbindung bereits ohne Lötprozess gewährleistet. Fig. 7 zeigt den Zustand bei der Herstellung kurz bevor mit Hilfe des Rakelwerkzeugs 30 die Rakel 32 über die Öffnung in der Druckschablone 33 gestrichen wird, um die Lötpaste 24 in den abgesenkten Bereich 12 des spritzgegossenen Schaltungsträgers 10 zu streichen. Insbesondere ist auch hier erkennbar, dass der Kontaktstift 34 diesen Streichprozess nicht behindern wird, da er nicht über die Druckschablone 33 hinaus steht.

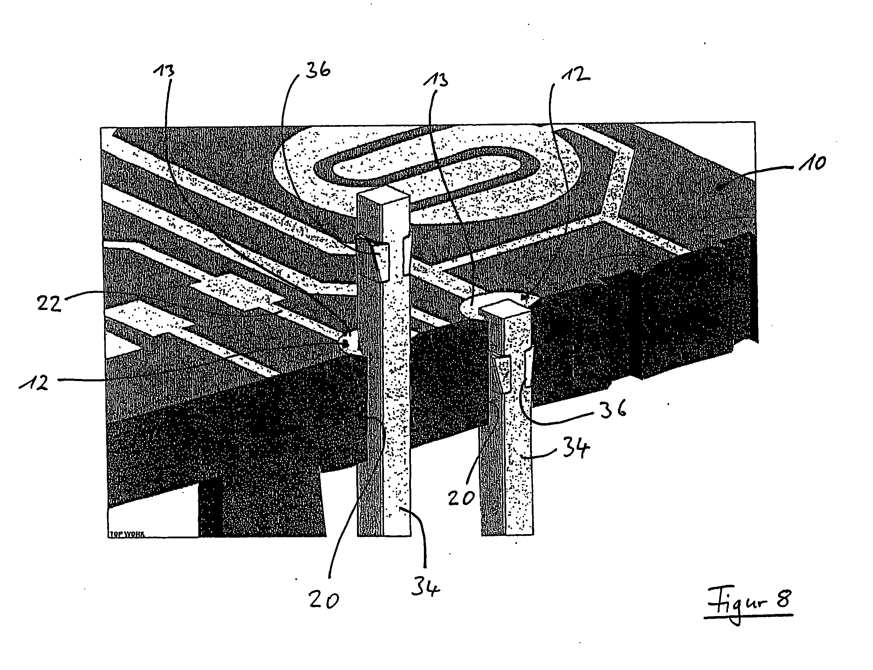

Fig. 8 zeigt im perspektivischen Teilschnitt eine andere Ausgestaltung. Hier sind viereckige Kontaktstifte 34 vorgesehen, die an ihrem oberen Ende Widerhaken 36 aufweisen. Solche Kontaktstifte 34 können ebenfalls in die Öffnung eingepresst werden, so dass sich die Widerhaken 36 in dem spritzgegossenen Schaltungsträger 10 verkeilen.

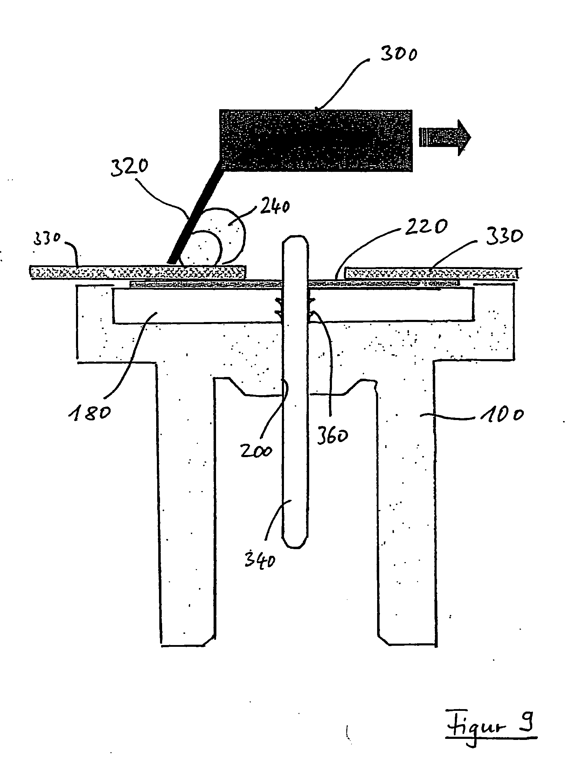

Fig. 9 zeigt zum Vergleich mit den erfindungsgemäßen Ausführungsformen eine konventionelle Anordnung. In einem spritzgegossenen Träger 100 ist hier eine gedruckte Leiterplatte 180 angeordnet, in der mit Hilfe von Halteelementen 360 ein Kontaktstift 340 gehalten wird. Der Kontaktstift ist also nicht in der Öffnung 200 in dem spritzgegossenen Träger 100 verankert. Mechanische Belastungen zwischen Kontaktstift 340 und Leiterplatte 180 werden also in die Lötstelle geleitet. Damit ein ausreichend stabiler Lötkontakt zwischen dem Kontaktstift 340 und der Leiterbahn 220 hergestellt werden kann, muss der Kontaktstift 340 signifikant über die Leiterbahn 220 hinaus stehen. Insbesondere da der Kontaktstift 340 nur in der flachen Leiterplatte 180 befestigt ist, ist eine stabile Lötverbindung notwendig, die ausreichend Lötpaste umfasst, um den mechanischen Belastungen zu widerstehen. Während mit Hilfe des Rakelwerkzeugs 300 die Rakel 320 in Pfeilrichtung über die Öffnung in der Druckschablone 330 gezogen wird, um die Lötpaste 240 zu verstreichen, kann es zu einer Kollision der Rakel 320 mit dem Kontaktstift 340 kommen. Insofern muss die Rakel entweder derart angeordnet sein, dass eine solche Kollision vermieden wird, oder besondere Vorkehrungen getroffen werden, dass eine Kollision nicht hinderlich ist, insbesondere z.B. die Rakel ausreichend flexibel ist.

### Bezugszeichenliste

- 10: spritzgegossener Schaltungsträger (MID)
- 12: abgesenkter Bereich
- 13: metallisierter Bereich
- 14: Kontaktstift
- 16: Sternkopf
- 20: Durchgangsöffnung
- 22: Leiterbahn
- 23: Lötpaste nach dem Lötprozess
- 24: Lötpaste während des Verstreichens
- 25: verstrichene Lötpaste
- 26: Einsteckwerkzeug
- 28: Nachdrückwerkzeug
- 30: Rakelwerkzeug
- 32: Rakel
- 33: Druckschablone
- 34: Kontaktstift
- 36: Widerhaken
- 100: spritzgegossener Träger
- 180: gedruckte Leiterplatte
- 200: Durchgangsöffnung
- 220: Leiterbahn
- 240: Lötpaste während des Verstreichens
- 300: Rakelwerkzeug
- 320: Rakel
- 330: Druckschablone
- 340: Kontaktstift
- 360: Widerhaken
- L: Überstand des Kontaktstifts
- D: Dicke der Druckschablone

## Patentansprüche

1. Elektrisches Kontaktelement mit
- einer Oberfläche,
- wenigstens einer Leiterbahn (22) auf der Oberfläche und
- wenigstens einer, vorzugsweise als Durchgangsöffnung (20) ausgestalteten, Öffnung in der Oberfläche für einen Kontaktstift (14, 34),
wobei die wenigstens eine Öffnung (20) von einem abgesenkten, zumindest teilweise metallisierten Bereich (12) der Oberfläche umgeben ist, dessen Metallisierung (13) mit der Leiterbahn in elektrischem Kontakt ist

2. Elektrisches Kontaktelement nach Anspruch 1, bei dem der abgesenkte Bereich (12) trichterförmig ist.

3. Elektrisches Kontaktelement nach einem der Ansprüche 1 oder 2, bei dem der abgesenkte Bereich (12) vollständig metallisiert ist.

4. Elektrisches Kontaktelement nach einem der Ansprüche 1 bis 3, bei dem das Kontaktelement einen spritzgegossenen Schaltungsträger (10) in Form eines Formkunststoffteils (10) umfasst, auf dessen Oberfläche die wenigstens eine Leiterbahn (22) vorzugsweise direkt aufgebracht ist.

5. Elektrisches Kontaktelement nach Anspruch 4, bei dem das Formkunststoffteil (10) spritzgegossen ist.

6. Elektrisches Verbindungssystem mit
- einem elektrischen Kontaktelement (10) nach einem der Ansprüche 1 bis 5,
- wenigstens einem Kontaktstift (14, 34) zur Aufnahme in der wenigstens einen Öffnung (20) des elektrischen Kontaktelementes (10).

7. Elektrisches Verbindungssystem nach Anspruch 6, bei dem der wenigstens eine Kontaktstift (14, 34) derart ausgestaltet ist, dass er die Oberfläche des Kontaktelementes (10), in der sich der abgesenkte Bereich (12) befindet, nur maximal so weit überragt, dass er nicht höher als die Dicke (D) einer Druckschablone (33) über die Oberfläche hervorsteht, wenn er sich in der wenigstens einen Öffnung (20) des Kontaktelementes (10) befindet, vorzugsweise derart, dass der Kontaktstift (14, 34) die Oberfläche um maximal 200 Mikrometer, bevorzugt maximal 90 Mikrometer, überragt.

8. Elektrisches Verbindungssystem nach Anspruch 7, bei dem der wenigstens eine Kontaktstift derart ausgestaltet ist, dass er die Oberfläche des Kontaktelementes, in der sich der abgesenkte Bereich befindet, nicht überragt, wenn er in der wenigstens einen Öffnung des Kontaktelementes aufgenommen ist.

9. Elektrisches Verbindungssystem nach einem der Ansprüche 6 bis 8, bei dem der wenigstens eine Kontaktstift (14, 34) in der wenigstens einen Öffnung (20) des Kontaktelement (10) verankerbar ist.

10. Elektrisches Verbindungssystem nach einem der Ansprüche 6 bis 9, bei dem der wenigstens eine Kontaktstift (14, 34) in der wenigstens einen Öffnung (20) des Kontaktelementes (10) aufgenommen bzw. verankert ist.

11. Elektrisches Verbindungssystem nach Anspruch 10, bei dem der wenigstens eine abgesenkte Bereich (12) in der Oberfläche des Kontaktelementes (10) mit Lötpaste (25) gefüllt ist.

12. Elektrisches Verbindungssystem nach einem der Ansprüche 10 oder 11, bei dem das Kontaktelement einen spritzgegosssenen Schaltungsträger (10) umfasst und der wenigstens eine Kontaktstift (34) von dem spritzgegosssenen Schaltungsträger (10) umspritzt ist.

13. Elektrisches Verbindungssystem nach einem der Ansprüche 6 bis 12, bei dem der Kontaktstift als Rundstift (14) mit einem Sternkopf (16) ausgebildet ist.

14. Elektrisches Verbindungssystem nach einem der Ansprüche 6 bis 12, bei dem der Kontaktstift (34) Widerhaken (36) umfasst.

15. Verfahren zur Herstellung eines elektrischen Verbindungssystems, bei dem eine Druckschablone (33) mit wenigstens einer Druckaussparung derart auf ein elektrisches Kontaktelement (10) nach einem der Ansprüche 1 bis 5 mit wenigstens einem darin aufgenommenen bzw. verankerten oder darin integrierten Kontaktstift (14, 34) aufgebracht wird, dass die wenigstens eine Druckaussparung den wenigstens einen Kontaktstift (14, 34) freilässt, und Lötpaste (24, 25) mit einer Rakel (32) in die wenigstens eine Druckaussparung gestrichen wird, wobei die Rakel (32) über die wenigstens eine Druckaussparung und den wenigstens einen Kontaktstift (14, 34) gestrichen wird.

## Geänderte Patentansprüche

### Geänderte Patentansprüche gemäss Regel 86(2) EPÜ.

**1.** Elektrisches Verbindungssystem umfassend
- einen spritzgegossenen Schaltungsträger (10) in Form eines Formkunststoffteils als Kontaktelement, mit wenigstens einer Leiterbahn (22) auf einer Oberfläche und wenigstens einer, vorzugsweise als Durchgangsöffnung (20) ausgestalteten, Öffnung in der Oberfläche für einen Kontaktstift (14, 34), wobei die wenigstens eine Öffnung (20) von einem abgesenkten, zumindest teilweise metallisierten Bereich (12) der Oberfläche umgeben ist, dessen Metallisierung (13) mit der Leiterbahn in elektrischem Kontakt ist, und
- wenigstens einen Kontaktstift (14, 34) zur Aufnahme in der wenigstens einen Öffnung (20) des Formkunststoffteils (10).

**2.** Elektrisches Verbindungssystem nach Anspruch 1, bei dem der abgesenkte Bereich (12) trichterförmig ist.

**3.** Elektrisches Verbindungssystem nach einem der Ansprüche 1 oder 2, bei dem der abgesenkte Bereich (12) vollständig metallisiert ist.

**4.** Elektrisches Verbindungssystem nach einem der Ansprüche 1 bis 3, bei dem die wenigstens eine Leiterbahn (22) direkt auf der Oberfläche des Formkunststoffteiles aufgebracht ist.

**5.** Elektrisches Verbindungssystem nach einem der Ansprüche 1 bis 4, bei dem der wenigstens eine Kontaktstift (14, 34) derart ausgestaltet ist, dass er die Oberfläche des Kontaktelementes (10), in der sich der abgesenkte Bereich (12) befindet, nur maximal so weit überragt, dass er nicht höher als die Dicke (D) einer Druckschablone (33) über die Oberfläche hervorsteht, wenn er sich in der wenigstens einen Öffnung (20) des Kontaktelementes (10) befindet, vorzugsweise derart, dass der Kontaktstift (14, 34) die Oberfläche um maximal 200 Mikrometer, bevorzugt maximal 90 Mikrometer, überragt.

**6.** Elektrisches Verbindungssystem nach Anspruch 5, bei dem der wenigstens eine Kontaktstift derart ausgestaltet ist, dass er die Oberfläche des Kontaktelementes, in der sich der abgesenkte Bereich befindet, nicht überragt, wenn er in der wenigstens einen Öffnung des Kontaktelementes aufgenommen ist.

**7.** Elektrisches Verbindungssystem nach einem der Ansprüche 1 bis 6, bei dem der wenigstens eine Kontaktstift (14, 34) in der wenigstens einen Öffnung (20) des Kontaktelement (10) verankerbar ist.

**8.** Elektrisches Verbindungssystem nach einem der Ansprüche 1 bis 7, bei dem der wenigstens eine Kontaktstift (14, 34) in der wenigstens einen Öffnung (20) des Kontaktelementes (10) aufgenommen bzw. verankert ist.

**9.** Elektrisches Verbindungssystem nach Anspruch 8, bei dem der wenigstens eine abgesenkte Bereich (12) in der Oberfläche des Kontaktelementes (10) mit Lötpaste (25) gefüllt ist.

**10.** Elektrisches Verbindungssystem nach einem der Ansprüche 8 oder 9, bei dem der wenigstens eine Kontaktstift (34) von dem spritzgegosssenen Schaltungsträger (10) umspritzt ist.

**11.** Elektrisches Verbindungssystem nach einem der Ansprüche 1 bis 10, bei dem der Kontaktstift als Rundstift (14) mit einem Sternkopf (16) ausgebildet ist.

**12.** Elektrisches Verbindungssystem nach einem der Ansprüche 1 bis 10, bei dem der Kontaktstift (34) Widerhaken (36) umfasst.

**13.** Verfahren zur Herstellung eines elektrischen Verbindungssystems gemäß einem der vorhergehenden Ansprüche, bei dem eine Druckschablone (33) mit wenigstens einer Druckaussparung derart auf das elektrische Kontaktelement (10) mit wenigstens einem darin aufgenommenen bzw. verankerten oder darin integrierten Kontaktstift (14, 34) aufgebracht wird, dass die wenigstens eine Druckaussparung den wenigstens einen Kontaktstift (14, 34) freilässt, und Lötpaste (24, 25) mit einer Rakel (32) in die wenigstens eine Druckaussparung gestrichen wird, wobei die Rakel (32) über die wenigstens eine Druckaussparung und den wenigstens einen Kontaktstift (14, 34) gestrichen wird.
